# EUROPÄISCHE PATENTSCHRIFT

(11) **EP 0 304 680 B1**
(45) Veröffentlichungstag und Bekanntmachung des Hinweises auf die Patenterteilung: **29.12.1993**
(21) Anmeldenummer: 88112520.7
(22) Anmeldetag: 02.08.1988
(51) Int. Cl.: H03F 3/30

(54) **Integrierte komplementäre Gegentakt-B-Endstufe**
Integrated complementary push-pull class B output power amplifier
Amplificateur push-pull de puissance à semi-conducteurs complémentaires du type classe B à circuit intégré

(30) Priorität: 22.08.1987 DE 3728078
(43) Veröffentlichungstag der Anmeldung: 01.03.1989
(73) Patentinhaber: TEMIC TELEFUNKEN microelectronic GmbH, 74072 Heilbronn (DE)
(72) Erfinder: Mattfeld, Johann, Dipl.-Ing., D-7104 Obersulm 3 (DE)
(74) Vertreter: Maute, Hans-Jürgen, Dipl.-Ing.

(56) Entgegenhaltungen:
- DE-A- 2 554 770
- GB-A- 2 043 337
- US-A- 4 160 216

## Beschreibung

Die Erfindung betrifft eine komplementäre Gegentakt-B-Endstufe mit komplementären Treibertransistoren, deren Emitter direkt miteinander verbunden sind, wobei zwischen den verbundenen Emittern der Treibertransistoren und dem Bezugspotential eine in Bezug auf den Innenwiderstand der Treibertransistoren dynamisch niederohmige Schaltung geschaltet ist.

Aus der DE-PS 2554770 ist ein solcher Transistor-Gegentaktverstärker mit einer Gegentakt-Treiberstufe mit zwei komplementären Transistoren und einer Gegentakt-B-Endstufe, die ebenfalls zwei komplementäre Transistoren enthält, bekannt.

Gemäß Figur 2 der oben genannten Druckschrift dienen zur Ansteuerung dieser komplementären Gegentakt-B-Endstufe die komplementären Treibertransistoren, deren Emitter direkt miteinander verbunden sind. Da das Gleichspannungspotential dieser Emitter etwa auf halbem Betriebsspannungspotential liegt, können diese an die Verbindung der beiden Kollektoren der Endstufentransistoren angeschlossen werden. Die Verbindung der beiden Kollektoren der Endstufentransistoren muß zur Erzielung einer hohen Ausgangsleistung eine Gleichspannung entsprechend der halben Betriebsspannung aufweisen. Zur Vermeidung einer verstärkungsmindernden Gegenkopplung wird diese Verbindung über ein Siebglied, bestehend aus ein bzw. zwei Widerständen und einem Kondensator, hergestellt.

Für integrierte Schaltungen ist diese Schaltungsanordnung nicht brauchbar, da der Kondensator des Siebgliedes aufgrund des hohen Kapazitätswertes (in der genannten Druckschrift: 22 µF) nicht integrierbar ist. Somit müßte der Schaltungspunkt zwischen dem bzw. den Siebwiderständen und den Emittern der Treibertransistoren als Anschlußpunkt herausgeführt werden, wodurch zusätzliche Kosten entstehen.

Weiterhin ist auch aus der GB-A-2 043 337 eine auf einem Halbleiterkörper integrierte komplementäre Gegentakt-B-Endstufe mit komplementären Treibertransistoren bekannt, deren Emitter direkt miteinander verbunden sind. Ein Nachteil dieser bekannten Schaltung liegt darin, daß zwischen den verbundenen Emittern der Treibertransistoren und dem Bezugspotential eine Spannungsquelle vorgesehen ist, die die halbe Betriebsspannung erzeugt und nicht auf dem Halbleiterkörper mit den anderen Bauelementen mitintegriert ist.

Der Erfindung liegt die Aufgabe zugrunde, eine komplementäre Gegentakt-B-Endstufe der eingangs beschriebenen Art zu schaffen, die leicht auf einem Halbleiterkörper integrierbar ist.

Erfindungsgemäß wird diese Aufgabe durch die kennzeichnenden Merkmale des Patentanspruches 1 gelöst.

Durch die erfindungsgemäße Ausbildung der komplementären Gegentakt-B-Endstufe wird die oben gestellte Forderung erfüllt, wobei sich eine integrierte Schaltung ergibt, deren Herstellung keine untragbare Modifikation der Technologie bedarf und die kein zusätzliches Anschlußpin für einen externen Kondensator oder eine externe Spannungsquelle benötigt.

Zweckmäßige Ausgestaltungen der Erfindung sind Gegenstand der Unteransprüche.

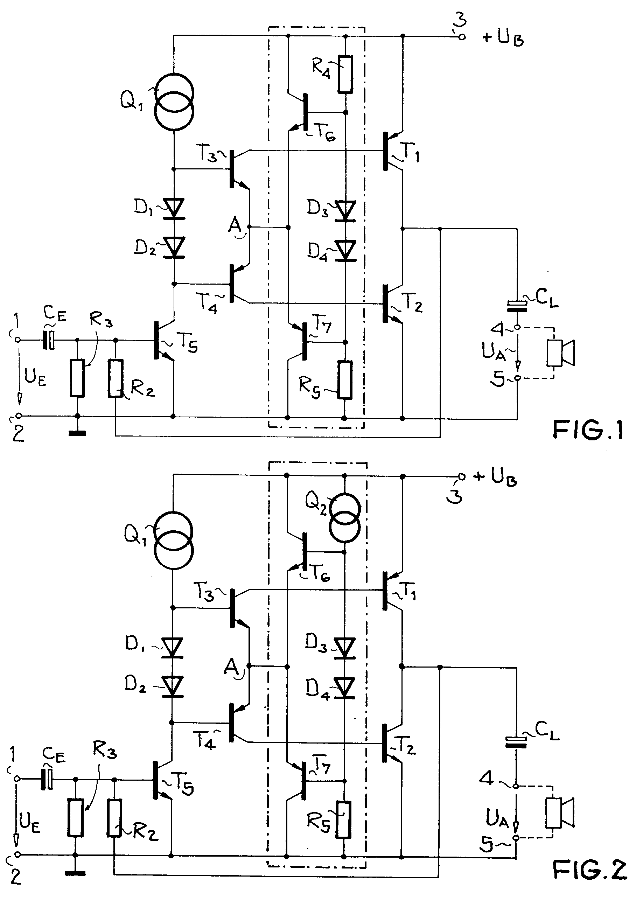

Im folgenden sind bevorzugte Ausführungsformen der Erfindung anhand der Figuren 1 - 3 näher erläutert.

Eine erste erfindungsgemäße Ausführungsform einer integrierbaren komplementären Gegentakt-B-Endstufe nach Figur 1 hat zwei Anschlüsse 1, 2 zum Zuführen von mit dem Verstärker zu verstärkenden Wechselstromsignalen der Spannung U_{E}, wobei der Anschluß 2 auf Masse liegt und der Anschluß 1 über einen Kondensator C_{E} mit der Basis eines Transistors T₅ in Verbindung steht, dessen Emitter auf dem Massepotential liegt und dessen Kollektor erstens mit der Basis eines pnp-Treibertransistors T₄ und zweitens über zwei in Reihe und bezüglich der Betriebsspannung in Durchlaßrichtung geschaltete Dioden D₁ und D₂ mit der Basis des npn-Treibertransistors T₃ verbunden ist, so daß die Transistoren T₃ und T₄ eine komplementäre Gegentakt-Treiberstufe bilden, deren Emitter unmittelbar miteinander verbunden sind (Schaltungspunkt A). Die Basis des Treibertransistors T₃ steht außerdem über eine Stromquelle Q₁ mit einem Anschluß 3 einer Betriebsspannungsquelle in Verbindung, die eine Gleichspannung U_{B} liefert.

Während die Kollektoren der Transistoren T₁ und T₂ direkt miteinander verbunden sind, schließt sich an die Basis des pnp-Transistors T₁ der Kollektor des Treibertransistors T₃ und an die Basis des npn-Transistors T₂ der Kollektor des Treibertransistors T₄ an. Die Transistoren T₁ und T₂ bilden eine komplementäre GegentaktB-Endstufe, wobei der Emitter des Endstufentransistors T₁ auf dem positiven, Betriebspotential des Anschlusses 3 und der Emitter des Endstufentransistors T₂ auf dem Massepotential liegt.

Die beiden miteinander verbundenen Kollektoren der Endstufentransistoren T₁ und T₂ stehen erstens über einen Kondensator C_{L} mit einem Anschluß 4 in Verbindung, der zusammen mit einem auf dem Massepotential liegenden Anschluß 5 den Ausgang der Gegentakt-Endstufe bildet.
Zweitens steht der Verbindungspunkt zwischen den Kollektoren der Endstufentransistoren über einen Widerstand R₂ mit der Basis des Eingangstransistors T₅ in Verbindung. Zwischen die Basis des Eingangstransistors und Bezugspotentials ist ein Widerstand R₃ geschaltet. Der Kondensator C_{E} dient zur Ankopplung des Eingangssignales U_{E}.

Außer den komplementären Transistoren T₃ und T₄ bzw. T₁ und T₂ in der Treiberstufe und in der Gegentakt-B-Endstufe sind auch die Transistoren T₁ und T₃ bzw. T₂ und T₄ zueinander komplementär.

Der vorstehend beschriebene Teil der komplementären Gegentakt-B-Endstufe mit einem komplementären Treibertransistorpaar ist aus der oben genannten Druckschrift bekannt.

Wie bereits oben erwähnt, kann das beim Stand der Technik bekannte, zwischen dem Verbindungspunkt A der Emitter der Treibertransistoren T₃ und T₄ und dem Verbindungspunkt der Kollektoren der Endstufentransistoren T₁ und T₂ geschaltete Siebglied nicht integriert werden. Daher wird nach Figur 1 auf das bekannte Siebglied verzichtet und durch eine integrierbare Schaltung ersetzt, die aus einem weiteren komplementären Transistorpaar T₆ und T₇ besteht, deren Emitter zusammengeschaltet und mit dem Schaltungspunkt A verbunden sind, während der Kollektor des Transistors T₆ auf dem positiven Betriebspotential des Anschlusses 3 und der Kollektor des Transistors T₇ auf dem Massepotential liegt. Außerdem ist die Basis des Transistors T₆ über einen Widerstand R₄ mit dem positiven Betriebspotential des Anschlusses 3 und die Basis des Transistors T₇ über den Widerstand R₅ mit dem Massepotential verbunden. Darüber hinaus sind die Basen der Transistoren T₆ und T₇ über zwei in Reihe geschaltete Dioden D₃ und D₄ verbunden, wodurch zusammen mit den Widerständen R₄ und R₅ ein Spannungsteiler entsteht. Durch die gleich großen Widerstände R₄ und R₅ wird gewährleistet, daß die Gleichspannung an der Emitterverbindung der Transistoren T₆ und T₇ etwa der halben Betriebsspannung entspricht. Ferner sorgen die Dioden D₃ und D₄ dafür, daß durch die Transistoren T₆ und T₇ ein ausreichend großer Gleichstrom fließt. Weiterhin wird durch die Basisgrundschaltung der Transistoren T₆ und T₇ der geforderte, dynamische niederohmige Widerstand an den Emittern der Transistoren T₃ und T₄ gewährleistet.

Da die erfindungsgemäße integrierte Schaltung nach Figur 1 in einem großen Betriebsspannungsbereich eingesetzt wird, ändert sich auch der Strom durch den Spannungsteiler R₄, R₅, D₃ und D₄ entsprechend stark, was unter Umständen als nachteilig empfunden wird. Um diesen Nachteil zu vermeiden, kann bei einer weiteren erfindungsgemäßen Ausbildung der Widerstand R₄ bzw. R₅ durch eine Stromquelle Q₂ ersetzt werden, so daß der Ruhestrom der Schaltung unabhängig von der Betriebsspannung praktisch konstant ist. Die Spannung an dem Verbindungspunkt A der Emitter der Transistoren T₃, T₄, T₆ und T₇ entspricht dann bei Betriebsspannungsveränderungen nicht mehr exakt der halben jeweiligen Betriebsspannung, ist aber so dimensionierbar, daß in einem, im allgemeinen ausreichend weiten Bereich der Betriebsspannungsveränderung ein optimaler Betrieb gewährleistet ist. Eine solche Schaltung, bei der der Widerstand R₄ durch eine Stromquelle Q₂ ersetzt ist, ist in Figur 2 dargestellt. Im übrigen stimmt die Schaltung nach Figur 2 mit der der Figur 1 überein.

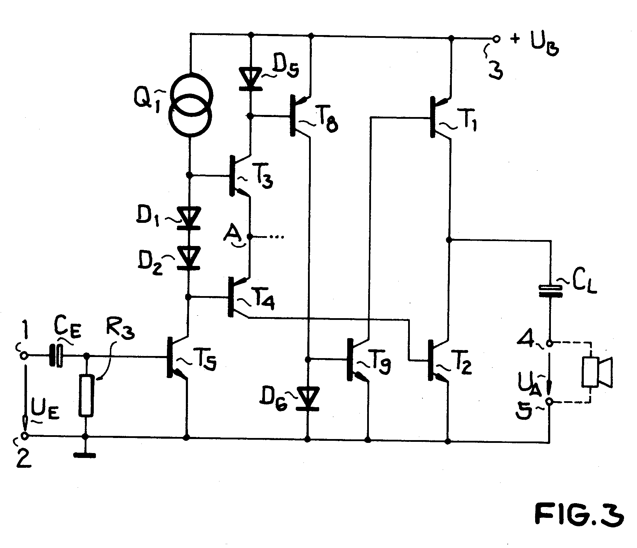

Ein weiteres Ausführungsbeispiel der Erfindung zeigt die Figur 3, bei der die Basis des Endstufentransistors T₁ über eine Stromspiegelschaltung angesteuert wird. Diese Schaltung ist dann mit Vorteil anzuwenden, wenn aus technologischen Gründen die Stromverstärkung einer der beiden Endstufentransistoren bei hohen Kollektorströmen gering ist.

Nach Figur 3 besteht diese Stromspiegelschaltung aus einem pnp-Transistor T₈, dessen Basis einerseits mit dem Kollektor des Treibertransistors T₃ verbunden ist und andererseits über eine Diode D₅ auf dem positiven Betriebspotential des Anschlusses 3 liegt und einem npn-Transistor T₉, dessen Basis erstens mit dem Kollektor des Transistors T₈ verbunden ist und zweitens über eine Diode D₆ auf Masse liegt, während der Kollektor mit der Basis des Endstufentransistors T₁ verbunden ist. Die beiden Emitter der Transistoren T₈ und T₉ liegen auf dem positiven Betriebspotential bzw. auf Masse, während die Emitter der beiden Treibertransistoren T₃ und T₄ direkt über den Schaltungspunkt A miteinander verbunden sind.

Der Schaltungspunkt A kann nun über eine der Ausführungsformen der erfindungsgemäßen integrierbaren Zusatzschaltung an die beiden Pole der Betriebsspannungsquelle angeschlossen werden, wobei diese Ausführungsformen in den Schaltungen der Figuren 1 und 2 dargestellt sind und sich jeweils auf den Teil der Schaltungen beziehen, der zwischen dem Schaltungspunkt A und den beiden Polen der Betriebsspannungsquelle liegt und in einem punktgestrichelt gezeichneten Rechteck liegt. Durch die Ansteuerung des Endstufentransistors T₁ über die in Figur 3 dargestellte Stromspiegelschaltung wird die üblicherweise geringere Stromverstärkung des pnp-Endstufentransistors T₁ gegenüber dem npn-Endstufentransistor T₂ ausgeglichen.

## Patentansprüche

1. Komplementäre Gegentakt-B-Endstufe (T₁, T₂) mit komplementären Treibertransistoren (T₃, T₄), deren Emitter direkt miteinander verbunden sind, wobei zwischen den verbundenen Emittern der Treibertransistoren (T₃, T₄) und dem zweiten Pol einer Betriebspannungsquelle (U_{B}) eine in Bezug auf den Innenwiderstand der Treibertransistoren (T₃, T₄) dynamisch niederohmige Schaltung geschaltet ist, dadurch gekennzeichnet, daß diese Schaltung folgende Merkmale aufweist:
a) es ist ein komplementäres Transistorpaar (T₆, T₇) vorgesehen, deren Emitter zusammengeschaltet und mit den verbundenen Emittern der komplementären Treiberstufe (T₃, T₄) verbunden sind und deren Kollektoren jeweils an einen Pol der Betriebsspannungsquelle angeschlossen sind,
b) weiterhin ist ein erster Widerstand R₄ zwischen dem ersten Pol der Betriebsspannungsquelle und der Basis des ersten Transistors (T₆) des komplementären Transistorpaares (T₆, T₇) geschaltet,
c) ferner ist ein zweiter Widerstand R₅ zwischen dem zweiten Pol der Betriebsspannungsquelle und der Basis des zweiten Transistors (T₇) des komplementären Transistorpaares (T₆, T₇) geschaltet und
d) schließlich sind zwei in Reihe, bezüglich der Betriebsspannung in Durchlaßrichtung geschaltete Dioden (D₃, D₄) zur Verbindung der Basen der beiden Transistoren des komplementären Transistorpaares (T₆, T₇) vorgesehen.

2. Komplementäre Gegentakt-B-Endstufe (T₁, T₂) nach Anspruch 1, dadurch gekennzeichnet, daß einer der beiden Widerstände (R₄, R₅) durch eine Stromquelle (Q₂) ersetzt ist.

## Claims

1. Complementary class B push pull output stage (T₁, T₂) including complementary driver transistors (T₃, T₄) whose emitters are connected directly to each other wherein a circuit having a dynamically low resistance relative to the internal resistance of the driver transistors (T₃, T₄) is connected between the interconnected emitters of the driver transistors (T₃, T₄) and the second pole of an operating voltage source (U_{B}), characterised in that, this circuit has the following features:
a) there is provided a complementary transistor Pair (T₆, T₇) whose emitters are connected together and are connected to the interconnected emitters of the complementary driver stage (T₃, T₄) and whose collectors are respectively connected to a pole of the operating voltage source,
b) furthermore, a first resistor R4 is connected between the first pole of the operating voltage source and the base of the first transistor (T₆) of the complementary transistor pair (T₆, T₇),
c) further, a second resistor R₅ is connected between the second pole of the operating voltage source and the base of the second transistor (T₇) of the complementary transistor pair (T₆, T₇) and
d) finally, two diodes (D₃, D₄) connected in series in the forward direction of conduction with reference to the operating voltage are provided for the connection of the bases of the two transistors of the complementary transistor pair (T₆, T₇).

2. Complementary class B push pull output stage (T₁, T₂) in accordance with Claim 1, characterised in that, one of the two resistors (R₄, R₅) is replaced by a current source (Q₂).

## Revendications

1. Etage final push-pull ou symétrique (T₁, T₂), complémentaire, de classe B, comprenant des transistors d'attaque (T₃, T₄) complémentaires dont les émetteurs sont reliés directement entre eux, dans lequel un circuit dynamiquement de faible valeur ohmique, par rapport à la résistance interne des transistors d'attaque (T₃, T₄), est connecté entre les émetteurs reliés entre eux des transistors d'attaque (T₃, T₄) et le second pôle d'une source de tension de service (U_{B}), caractérisé en ce que ce circuit présente les particularités suivantes:
a) on a prévu une paire de transistors complémentaires (T₆, T₇) dont les émetteurs sont connectés entre eux et aux émetteurs reliés entre eux de l'étage d'attaque complémentaire (T₃, T₄) et dont les collecteurs sont raccordés chaque fois à un pôle de la source de tension de service,
b) une première résistance (R₄) est connectée en outre entre le premier pôle de la source de tension de service et la base du premier transistor (T₆) de la paire de transistors complémentaires (T₆, T₇),
c) une seconde résistance (R₅) est connectée en plus entre le second pôle de la source de tension de service et la base du second transistor (T₇) de la paire de transistors complémentaires (T₆, T₇) et
d) enfin, on a prévu deux diodes (D₃, D₄), montées en série et dans le sens passant par rapport à la tension de service, pour relier entre elles les bases des deux transistors de la paire de transistors complémentaires (T₆, T₇).

2. Etage final symétrique (T₁, T₂) complémentaire selon la revendication 1, caractérisé en ce que l'une des deux résistances (R₄, R₅) est remplacée par une source de courant (Q₂).
